# DEMANDE DE BREVET EUROPEEN

(11) **EP 4 362 109 A1**
(43) Date de publication de la demande: **01.05.2024**
(21) Numéro de dépôt: 22315246.3
(22) Date de dépôt: 27.10.2022
(51) Int. Cl.: H01L 31/042

(54) **EQUIPEMENT PHOTOVOLTAÏQUE**

(71) Demandeur: TotalEnergies OneTech, 92400 Courbevoie (FR)
(72) Inventeur: Matrat, David, 92400 Courbevoie (FR)
(74) Mandataire: Innovincia

(57) **Abrégé**

L'invention concerne un module photovoltaïque (7) configuré pour être disposé au-dessus d'une zone de cultures ou d'élevage (3) et comprenant :
- une pluralité de cellules photovoltaïques (9),
dans lequel les cellules photovoltaïques (9) sont des cellules photovoltaïques (9) découpées au moins deux fois dans une direction prédéterminée, interconnectées et espacées les unes des autres d'un écartement prédéterminé (d1) dans une direction perpendiculaire à la direction prédéterminée de découpe des cellules photovoltaïques (9).

## Description

La présente invention concerne un équipement photovoltaïque et plus particulièrement un équipement photovoltaïque d'agrivoltaïsme destiné à être installé dans une zone de cultures ou d'élevage, par exemple au-dessus d'un champ ou au niveau d'une serre.

L'agrivoltaïsme se développe de plus en plus car il permet d'une part de pouvoir installer des modules photovoltaïques sur de vastes étendues permettant ainsi une production importante d'énergie électrique et d'autre part d'apporter un revenu supplémentaire aux agriculteurs tout en pouvant continuer à exploiter leurs terres.

La mise en place de panneaux photovoltaïques dans une zone de cultures peut être faite de diverses façons mais la plupart présente des inconvénients pour l'exploitant agricole.

En effet, les cellules photovoltaïques n'étant pas transparentes, l'installation de panneaux photovoltaïques créent des zones d'ombres qui peuvent ralentir voire empêcher la croissance des plantes.

Une première solution vise à alterner les rangs de panneaux photovoltaïques et les rangs de cultures mais cela limite la surface de panneaux photovoltaïques d'une part et d'autre part cela implique de fortes contraintes pour l'exploitant agricole pour circuler dans son champ.

Il est également connu des réaliser des panneaux photovoltaïques comprenant une alternance de rangées de cellules photovoltaïques et de rangées exemptes de cellules photovoltaïques ou de panneaux photovoltaïques dont les cellules photovoltaïques forment un damier permettant à une partie des rayons lumineux d'atteindre les cultures. Cependant, de telles configurations provoquent la formation d'ombrages pleins aux niveaux des cultures. Ces ombrages pleins entraînent une croissance différenciée des cultures qui est très néfaste pour l'exploitant agricole.

Une solution pour réduire voire supprimer ces ombrages pleins est d'augmenter la hauteur de la structure supportant les panneaux photovoltaïques.

Cependant, une structure plus haute requiert davantage de matériaux et doit être plus rigide pour résister aux contraintes extérieures et notamment au vent de sorte qu'une telle structure est très coûteuse.

Afin de résoudre au moins partiellement ces problèmes, la présente invention vise à permettre l'implantation d'ombrières photovoltaïques ayant un coût limité dans des zones agricoles et ne produisant pas un ombrage plein et donc une croissance différenciée des plantes situées sous l'ombrière photovoltaïque.

A cet effet, l'invention a pour objet un module photovoltaïque configuré pour être disposé au-dessus d'une zone de cultures ou d'élevage et comprenant :
- une pluralité de cellules photovoltaïques,
caractérisé en ce que les cellules photovoltaïques sont des cellules photovoltaïques découpées au moins deux fois dans une direction prédéterminée, interconnectées et espacées les unes des autres d'un écartement prédéterminé dans une direction perpendiculaire à la direction prédéterminée de découpe des cellules photovoltaïques.

L'utilisation de cellules photovoltaïques découpées, interconnectées et espacées permet d'obtenir un module photovoltaïque ayant un faible coût de revient et permettant de minimiser l'ombrage produit par les cellules photovoltaïques et donc de favoriser l'exploitation de cultures disposées sous le module photovoltaïque sans diminuer fortement la production électrique.

Selon un autre aspect de la présente invention, les cellules photovoltaïques coupées sont des cellules photovoltaïques dont la taille après découpe correspond à des cellules photovoltaïques de type shingle.

Selon un autre aspect de la présente invention, l'écartement prédéterminé est choisi en fonction du pourcentage de transparence voulu pour le module photovoltaïque.

Selon un autre aspect de la présente invention, l'écartement prédéterminé est supérieur à 5 mm.

Selon un autre aspect de la présente invention, la largeur des cellules photovoltaïques est choisie en fonction de la distance par rapport au sol du module photovoltaïque pour limiter ou supprimer un ombrage plein, dû aux cellules photovoltaïques, au niveau du sol.

Selon un autre aspect de la présente invention, la largeur des cellules photovoltaïques est inférieure à 55 mm, notamment inférieur à 50mm.

Selon un autre aspect de la présente invention, le module photovoltaïque comprend également une face arrière transparente en verre ou en matériau plastique, notamment en polyfluorure de vinyle.

Selon un autre aspect de la présente invention, les cellules photovoltaïques sont des cellules photovoltaïques bifaciales.

La présente invention concerne également une ombrière photovoltaïque comprenant :
- au moins un module photovoltaïque tel que décrit précédemment,
- un support sur lequel est disposé le, au moins un module photovoltaïque.

Selon un autre aspect de la présente invention, le support comprend une armature en bois, aluminium, acier, fonte, ou matériau composite, notamment une armature métallique, notamment en acier.

Selon un autre aspect de la présente invention, le support forme une serre.

D'autres caractéristiques et avantages de l'invention apparaîtront plus clairement à la lecture de la description suivante, donnée à titre d'exemple illustratif et non limitatif, et des dessins annexés parmi lesquels :
[Fig 1] représente une vue schématique d'une ombrière photovoltaïque ;
[Fig 2] représente un exemple de configuration d'un module photovoltaïque ;
[Fig 3] représente une vue schématique en perspective d'un module photovoltaïque et de l'ombrage associé ;
[Fig 4] représente une vue éclatée en perspective des différentes couches d'un module photovoltaïque.

Dans ces figures, les éléments identiques portent les mêmes références.

Les réalisations suivantes sont des exemples. Bien que la description se réfère à un ou plusieurs modes de réalisation, ceci ne signifie pas nécessairement que chaque référence concerne le même mode de réalisation, ou que les caractéristiques s'appliquent seulement à un seul mode de réalisation. De simples caractéristiques de différents modes de réalisation peuvent également être combinées ou interchangées pour fournir d'autres réalisations.

Dans la suite de la description, un écart de +/- 10% peut être appliqué sur les dimensions données sans sortir du cadre de la présente invention.

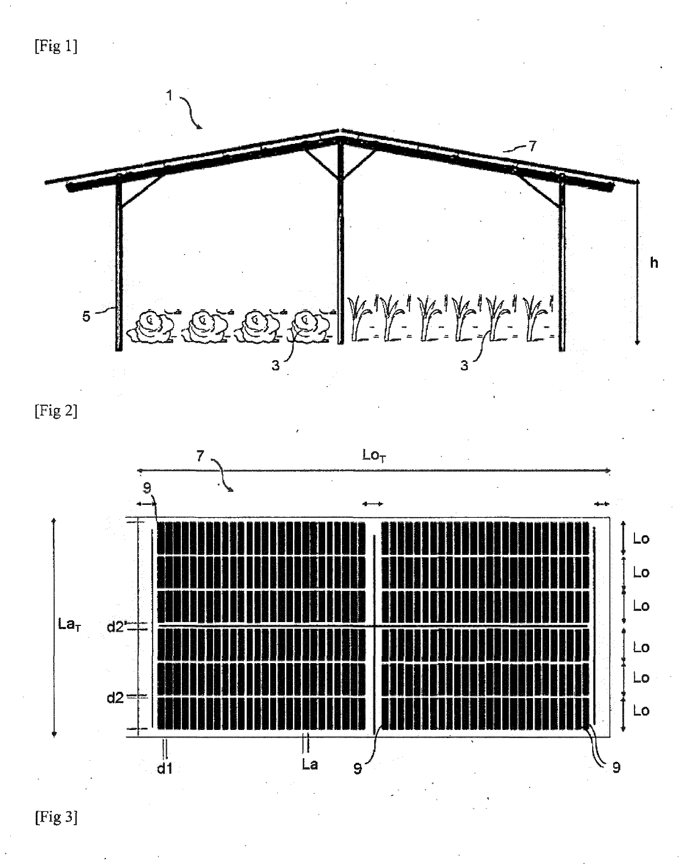

La présente invention concerne un module photovoltaïque pour agrivoltaïsme et une ombrière comprenant un ou plusieurs modules photovoltaïques. Le module photovoltaïque ou l'ombrière sont par exemple disposés au-dessus d'une zone de cultures ou d'élevage. La figure 1 représente une vue schématique d'une telle ombrière photovoltaïque 1 disposée au-dessus de cultures 3. Alternativement, l'ombrière photovoltaïque 1 peut être disposée au-dessus d'une zone d'élevage comprenant de l'herbe pour nourrir le bétail, par exemple des volailles, des bovins ou des ovins. L'ombrière photovoltaïque permet alors de générer une lumière moins intense pour le bien-être animal.

L'ombrière photovoltaïque 1 comprend par exemple un support 5 sur lequel sont disposés un ou plusieurs modules photovoltaïques 7 (l'ombrière photovoltaïque 1 comprend généralement une pluralité de modules photovoltaïques 7).

Le support 5 correspond par exemple à une charpente ou à de simples montants. Le support 5 est par exemple réalisé en acier mais d'autre matériaux comme l'aluminium, le bois, la fonte ou un matériau composite peuvent également être utilisés. Le support 5 peut également correspondre à une serre ou un abri (ouvert ou fermé) sur laquelle sont disposés les modules photovoltaïques 7.

Les modules photovoltaïques 7 sont disposés sur le support 5 et présentent une inclinaison et une hauteur par rapport aux cultures 3 qui peuvent varier fortement. Toutes les inclinaisons entre 0° (verticale) et 90° (horizontale) peuvent être envisagées. La hauteur h des modules photovoltaïques 7, c'est-à-dire la distance par rapport au sol comprenant les cultures, est par exemple choisie en fonction de l'inclinaison des modules photovoltaïques 7. Pour des modules photovoltaïques 7 horizontaux, la hauteur h choisie sera par exemple comprise entre 1,8m et 2,5m de manière à permettre à la fois à un exploitant agricole de pouvoir circuler facilement sous les modules photovoltaïques 7 et de limiter la hauteur de l'ombrière photovoltaïque 1 de manière à limiter les contraintes sur le support 5 et donc le coût de fabrication de l'ombrière photovoltaïque 1.

Dans le cas de modules photovoltaïques 7 verticaux, ces derniers pourront s'étendre jusqu'au sol d'une part (et être fixés directement au sol) et jusqu'à une hauteur de 2,5m d'autre part. Cependant, dans la plupart des cas, l'inclinaison des modules photovoltaïques 7 sera comprise entre 75° et 90° et la hauteur h de la partie basse des modules photovoltaïques 7 sera comprise entre 1,8m et 2,5m.

Les modules photovoltaïques 7 peuvent être fixes ou peuvent être positionnés sur un support 5 mobile, notamment pour fournir une fonction de « tracking » dans laquelle l'orientation des modules photovoltaïques 7 est choisie pour optimiser la production photovoltaïque.

Les modules photovoltaïques 7 comprennent une pluralité de cellules photovoltaïques 9 qui sont des cellules photovoltaïques coupées, interconnectées et espacées. Les cellules photovoltaïques 9 sont découpées au moins deux fois (c'est-à-dire en trois parties), notamment au moins trois fois (c'est-à-dire en quatre parties), notamment quatre fois (c'est-à-dire en cinq parties) ou cinq fois (c'est-à-dire en six parties) dans une direction prédéterminée pour permettre d'obtenir des cellules photovoltaïques 9 de taille réduite correspondant à une taille de cellules photovoltaïques de type shingle.

La figure 2 représente un exemple de réalisation d'un tel module photovoltaïque 7. Les cellules photovoltaïques 9 sont donc obtenues à partir de cellules photovoltaïques standards carrées dont les dimensions sont généralement de 166mm^{∗} 166mm ou 182mm^{∗} 182mm ou 210mm^{∗}210mm. Ces cellules standards sont découpées au moins deux fois dans une direction prédéterminée comme lors de la réalisation de bardeaux photovoltaïques avec l'utilisation de cellules découpées de type shingle. Cependant, contrairement aux bardeaux photovoltaïques qui visent à minimiser les interconnexions entre les cellules photovoltaïques en positionnant les cellules photovoltaïques de manière adjacente, les cellules photovoltaïques 9 sont ici espacées de quelques millimètres et interconnectées entre elles, par exemple via des bandeaux de connexion aussi appelés « round-wire busbars » en anglais.

Les cellules standards sont par exemple divisées par un facteur compris entre 2 et 10, notamment en 5 ou en 6 de manière à obtenir des cellules photovoltaïques 9 ayant une largeur La comprise entre 25mm et 50mm. La longueur Lo des cellules est donc comprise entre 160mm et 210mm.

L'espacement transversal d1 entre les cellules photovoltaïques 9 dans la direction perpendiculaire à la découpe, c'est-à-dire dans la direction de la largeur La des cellules photovoltaïques 9, aussi appelé « gap cell » en anglais, est par exemple compris entre 5mm et 25mm, notamment entre 8mm et 20mm, notamment 12mm. Cet espacement transversal dl peut être choisi en fonction de la transparence requise pour l'ombrière photovoltaïque 1. L'espacement transversal dl sera par exemple de 8mm pour obtenir une transparence de 30%, de 12mm pour obtenir une transparence de 35%, de 15mm pour obtenir une transparence de 40% ou de 20mm pour une transparence de 45%. La transparence peut être choisie en fonction du type de cultures 3 au-dessus desquelles est positionnée l'ombrière photovoltaïque 1 et de la production électrique désirée (plus la densité de cellules photovoltaïques 9 est grande, plus la transparence (et donc l'ensoleillement des cultures 3) est faible et plus la production électrique est forte (pour un ensoleillement donné)).

De plus, la largeur La des cellules photovoltaïques 9 et l'espacement transversal dl peuvent être choisis en fonction de la distance à laquelle est positionné le module photovoltaïque 7 par rapport aux cultures (correspondant ici à la hauteur h) de manière à éviter un ombrage plein au niveau des cultures 3.

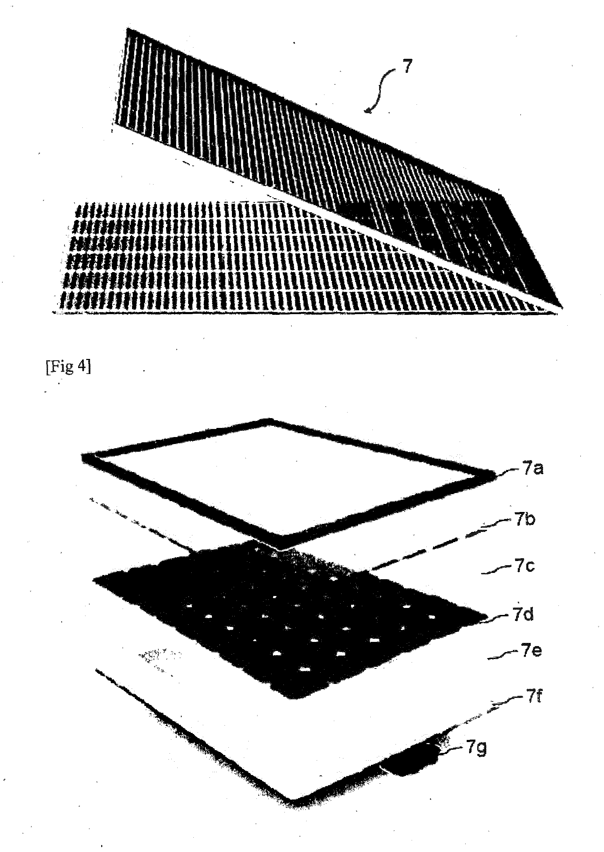

En effet, comme représenté sur la figure 3, le module photovoltaïque 7 peut produire un ombrage 8 au niveau des cultures 3 du fait de l'opacité des cellules photovoltaïques 9. Cependant, en fonction de la distance séparant le module photovoltaïque 7 et le sol où sont situées les cultures 3, une largeur La de cellules photovoltaïques 9 suffisamment fine et un espacement dl entre les cellules photovoltaïques 9 suffisamment important permet d'obtenir un ombrage diffus (et non un ombrage plein) de sorte que les cultures 3 sont toutes impactées sensiblement de la même manière par la présence de l'ombrière photovoltaïque 1 ce qui permet d'éviter des différences de croissance entre les différentes cultures 3 du fait d'un ensoleillement différent lié à un ombrage plein.

L'espacement longitudinal d2 entre les cellules photovoltaïques 9, aussi appelé « gap string » en anglais est par exemple compris entre 1mm et 15mm, notamment entre 1mm et 3mm, par exemple 2mm. Un espacement longitudinal d2' plus important, par exemple compris entre 8mm et 15mm, notamment égal à 10mm peut être introduit entre certaines rangées de cellules photovoltaïques 9, par exemple pour permettre le passage de connexions électriques.

La longueur totale Lo_{T} du module photovoltaïque 7 (dans la direction longitudinale des cellules photovoltaïques 9 dans le cas présent) est par exemple comprise entre 1500mm et 2500mm, notamment 2000mm et la largeur totale La_{T} (dans la direction transversale des cellules photovoltaïques 9 dans le cas présent) est par exemple comprise entre 700mm et 1500mm, notamment 1000mm.

Les cellules photovoltaïques 9 peuvent être des cellules photovoltaïques bifaciales afin de maximiser la production électrique. Dans ce cas, la couche arrière du module photovoltaïque 7 est une couche transparente comme la couche avant.

La figure 4 représente une vue en perspective des différentes couches d'un module photovoltaïque 7 selon un mode de réalisation de la présente invention.

Le module photovoltaïque 7 comprend un cadre 7a qui est optionnel, une couche avant transparente 7b, une couche avant d'encapsulation 7c, une couche 7d de cellules photovoltaïques découpées au moins deux fois pour obtenir une taille similaire aux cellules photovoltaïques de type shingle, espacées et interconnectées, une couche arrière d'encapsulation 7e, une couche arrière transparente 7f et une boîte de jonction 7g.

La couche avant transparente 7b est par exemple réalisée en verre et possède une épaisseur comprise entre 1mm et 5mm, notamment inférieure à 3mm, par exemple 2mm ou en polyfluorure de vinyle, aussi appelé « tedlar », et possède une épaisseur comprise entre 1mm et 5mm.

La couche arrière transparente 7f est par exemple réalisée en verre et possède une épaisseur comprise entre 2mm et 5mm, notamment inférieure à 3mm, par exemple 2mm ou en polyfluorure de vinyle et possède une épaisseur comprise entre 3mm et 5mm.

Un module photovoltaïque 7 peut comprendre une ou plusieurs boîtes de jonction 7g. Les boîtes de jonction 7g sont par exemple connectées entre elles par des câbles électriques.

Ainsi, l'utilisation de modules photovoltaïques 7 réalisés à partir de cellules photovoltaïques 9 découpées au moins deux fois, interconnectées et espacées les unes des autres d'un écartement prédéterminé d1 permet de minimiser les inconvénients liés à l'ombrage dû aux cellules photovoltaïques 9 sur les cultures en supprimant l'apparition d'un ombrage plein.

De plus, l'ombrage diffus produit par le module photoyoltaïque 7 peut être bénéfique en cas de fort ensoleillement pour réduire ou éviter un dessèchement des cultures ou une déshydratation et un inconfort du bétail tout en permettant une croissance homogène de l'herbe ou des cultures situées sous les modules photovoltaïques 7 ce qui permet de développer des fermes solaires avec une forte densité de modules photovoltaïques 7 sans compromettre les cultures.

Une telle configuration des modules photovoltaïque 7 peut également permettre la croissance de végétation sous des modules photovoltaïques 7 et permettre ainsi de développer des fermes solaires avec une grande densité de modules photovoltaïques 7 sans que cela détruise la biodiversité présente sur le lieu d'implantation des fermes solaires.

De plus, une telle configuration permet de maximiser la production électrique des modules photovoltaïques 7 pour une transparence donnée. De tels modules photovoltaïques 7 facilite ainsi l'installation de fermes solaires du fait que leur configuration réduit les inconvénients pour l'exploitant agricole des cultures au-dessus desquelles sont disposés les modules photovoltaïques 7 tout en permettant d'obtenir une production photovoltaïque intéressante pour leur exploitant du fait de la possibilité de couvrir de grandes surfaces.

## Revendications

1. Module photovoltaïque (7) configuré pour être disposé au-dessus d'une zone de cultures ou d'élevage (3) et comprenant :
- une pluralité de cellules photovoltaïques (9),
**caractérisé en ce que** les cellules photovoltaïques (9) sont des cellules photovoltaïques (9) découpées au moins deux fois dans une direction prédéterminée, interconnectées et espacées les unes des autres d'un écartement prédéterminé (d1) dans une direction perpendiculaire à la direction prédéterminée de découpe des cellules photovoltaïques (9).

2. Module photovoltaïque (7) selon la revendication 1 dans laquelle les cellules photovoltaïques coupées (9) sont des cellules photovoltaïques (9) dont la taille après découpe correspond à des cellules photovoltaïques de type shingle.

3. Module photovoltaïque (7) selon la revendication 1 ou 2 dans laquelle l'écartement prédéterminé (d1) est choisi en fonction du pourcentage de transparence voulu pour le module photovoltaïque (7).

4. Module photovoltaïque (7) selon la revendication 3 dans laquelle l'écartement prédéterminé (d1) est supérieur à 5 mm.

5. Module photovoltaïque (7) selon l'une des revendications précédentes dans laquelle la largeur (La) des cellules photovoltaïques (9) est choisie en fonction de la distance (h) par rapport au sol du module photovoltaïque (7) pour limiter ou supprimer un ombrage plein, dû aux cellules photovoltaïques (9), au niveau du sol.

6. Module photovoltaïque (7) selon la revendication 5 dans laquelle la largeur (La) des cellules photovoltaïques (9) est inférieure à 55 mm, notamment inférieur à 50mm.

7. Module photovoltaïque (7) selon l'une des revendications précédentes dans laquelle le module photovoltaïque (7) comprend également une face arrière transparente (7f) en verre ou en matériau plastique, notamment en polyfluorure de vinyle.

8. Module photovoltaïque (7) selon la revendication précédente dans laquelle les cellules photovoltaïques (9) sont des cellules . photovoltaïques bifaciales.

9. Ombrière photovoltaïque (1) comprenant :
- au moins un module photovoltaïque (7) selon l'une des revendications précédentes,
- un support (5) sur lequel est disposé le, au moins un module photovoltaïque (7).

10. Ombrière photovoltaïque (1) selon la revendication précédente dans laquelle le support (5) comprend une armature en bois, aluminium, acier, fonte, ou matériau composite, notamment une armature métallique, notamment en acier.

11. Ombrière photovoltaïque (1) selon la revendication 9 ou 10 dans laquelle le support (5) forme un abri ouvert ou fermé, notamment un auvent ou une serre.
